# FASCICULE DE BREVET EUROPEEN

(11) **EP 2 795 438 B1**
(45) Date de publication et mention de la délivrance du brevet: **12.09.2018**
(21) Numéro de dépôt: 12819086.5
(22) Date de dépôt: 18.12.2012
(51) Int. Cl.: G06F 3/044, G06F 3/041

(54) **DISPOSITIF ET PROCEDE DE MESURE CAPACITIVE SENSIBLE A LA PRESSION POUR INTERFACES TACTILES ET SANS CONTACT**
DRUCKEMPFINDLICHE KAPAZITIVE MESSVORRICHTUNG UND VERFAHREN FÜR EINE BERÜHRUNGSEMPFINDLICHE UND KONTAKTLOSE SCHNITTSTELLE
PRESSURE-SENSITIVE CAPACITIVE MEASUREMENT DEVICE AND METHOD FOR TOUCH-SENSITIVE AND CONTACTLESS INTERFACES

(30) Priorité: 21.12.2011 FR 1162125
(43) Date de publication de la demande: 29.10.2014
(73) Titulaire: QuickStep Technologies LLC, Wilmington, DE 19801 (US)
(72) Inventeur: ROZIERE, Didier, F-30900 Nîmes (FR)
(74) Mandataire: Lang, Johannes
(86) Numéro de dépôt international: PCT/FR2012/052972
(87) Numéro de publication internationale: WO 2013/093326

(56) Documents cités:
- EP-A2- 1 840 715
- WO-A2-2006/133018
- WO-A2-2009/126183
- US-A- 5 942 733
- US-A1- 2010 024 573

## Description

### Domaine technique

La présente invention concerne un dispositif de mesure capacitive sensible à la pression pour réaliser des interfaces homme-machines tactiles et sans contact. Elle concerne aussi un procédé de mesure capacitive sensible à la pression.

Le domaine de l'invention est plus particulièrement mais de manière non limitative celui de des interfaces homme-machine tactiles et sans contact.

### Etat de la technique antérieure

De nombreux appareils de communication et de travail utilisent une interface de commande tactile ou sans contact, tel qu'un pad ou un écran. On trouve par exemple ce genre d'interfaces dans des téléphones mobiles, des smartphones, des ordinateurs à écran tactile, des pads, des PC, des souris, des dalles tactiles et des écrans géants.....

Ces interfaces utilisent fréquemment les technologies capacitives. La surface sensible est équipée d'électrodes conductrices reliées à des moyens électroniques qui permettent de mesurer la variation des capacités apparaissant entre des électrodes et l'objet à détecter pour effectuer une commande.

Il est possible de réaliser des électrodes transparentes, qui permettent de superposer une interface sur un écran d'affichage, par exemple de smartphone.

La plupart de ces interfaces sont tactiles, c'est-à-dire qu'elles peuvent détecter le contact d'un ou de plusieurs objet(s) de commande (usuellement des doigts) avec la surface de l'interface.

Il se développe de plus en plus d'interfaces gestuelles ou sans contact, qui sont en mesure de détecter des objets de commande à une plus grande distance de l'interface, sans contact avec la surface.

Il existe deux grandes catégories de techniques de mesure capacitive pour des interfaces de commande :
- Des techniques de mesures directes de capacité de couplage entre les objets d'intérêt et les électrodes de mesure. Les électrodes sont réparties de telle sorte à couvrir la surface de mesure. Elles peuvent être constituées de surfaces contigües (patchs) couvrant toute la surface, ou de lignes et de colonnes croisées. La capacité entre chaque électrode et d'éventuels objets de commande est mesurée séquentiellement par une électronique de détection reliée aux électrodes par des scrutateurs ou d'autres moyens de commutation ;
- Des techniques de mesure de variation de couplage entre électrodes. Les électrodes sont réparties sous la forme de lignes et de colonnes croisées couvrant la surface de mesure et formant respectivement des électrodes d'excitation et des électrodes de mesure. Une électronique de détection mesure séquentiellement la capacité de couplage qui apparaît entre ces électrodes d'excitation et de mesure au niveau de leurs zones de recouvrement. La proximité d'objets de commande perturbe cette capacité de couplage, ce qui permet de les détecter.

Le développement d'interfaces sans contact nécessite la mise en oeuvre de techniques de mesure capacitive de très grande sensibilité et offrant une grande immunité aux perturbations de l'environnement. En effet, la capacité qui se crée entre des électrodes de mesure capacitive de l'interface et des objets de commande est inversement proportionnelle à la distance qui les sépare.

On connaît par exemple le document FR 2 756 048 de Rozière qui divulgue un procédé de mesure capacitive qui permet de mesurer la capacité et la distance entre une pluralité d'électrodes indépendantes et un objet à proximité.

Cette techniques permettent d'obtenir des mesures de capacité entre les électrodes et les objets avec une résolution et une sensibilité élevées, permettant de détecter par exemple un doigt à plusieurs centimètres voire à dix centimètres de distance. La détection peut se faire dans l'espace en trois dimensions (XYZ) mais également sur une surface, dans un plan (XY).

Si les interfaces sans contact sont amenées à prendre une grande importance, le toucher demeure toutefois très important, même dans les interfaces virtuelles capables de détecter les mouvements à distance, pour des raisons notamment psychologiques et de sécurité. En effet, d'une part la sensation tactile contribue au confort de l'utilisateur, d'autre part le toucher permet une validation des ordres efficace dans des contextes d'utilisation où la sécurité est importante (équipements médicaux, véhicules).

Or, dans les dispositifs capacitifs existants, la détection du contact est en général une détection du fait que la distance entre les objets de commande et les électrodes est très faible. Il n'y a en particulier pas de détection de pression ou de force d'appui permettant de valider un contact.

La détection du contact se complique lorsque l'utilisateur utilise un gant car malgré le contact physique, la capacité crée entre le doigt et la dalle peut être inférieure à la valeur prédérerminée qui déclenche la détection du toucher.

Un objet de la présente invention est de proposer une interface tactile et sans contact qui permette de détecter également un appui ou une pression.

Un autre objet de la présente invention est de proposer une telle interface qui puisse aisément être intégrée avec un dispositif d'affichage dans des appareils de type smartphone, avec un coût raisonnable.

D'autres dispositifs capacitifs connus de l'art antérieur US 5,942,733 A, WO 2006 / 133018 A2, US 2010 / 0024573 A1, WO 2009 / 126183 A2, EP 1 840 715 A2, décrivent la possibilité de capter aussi bien le toucher que la déformation d'une surface, et la possibilité d'utiliser un dispositif de garde pour améliorer la qualité des mesures.

### Exposé de l'invention

L'invention présente est définie par les revendications indépendantes 1 et 7. Des réalisation spécifiques sont définies dans les revendications dépendantes.

Le contexte de cette invention est donné par un dispositif de mesure capacitive pour interfaces de commande, comprenant :
- une plaque support en matériau diélectrique, avec des moyens de fixation sur une interface de commande,
- des premières électrodes en matériau sensiblement conducteur à l'électricité, disposées selon une première face de ladite plaque support à l'opposé de l'interface de commande, et comprenant des premières électrodes actives,
- des moyens électroniques de mesure capacitive aptes à permettre l'obtention d'informations d'approche et/ou de contact d'objet(s) d'intérêt par mesures de couplage capacitif avec lesdites premières électrodes actives, comprenant en outre des secondes électrodes en matériau sensiblement conducteur à l'électricité, disposées selon une seconde face de ladite plaque support vers l'interface de commande, et comprenant des secondes électrodes actives reliées auxdits moyens électroniques de mesure capacitive de telle sorte à permettre l'obtention de mesures de déplacement et/ou de déformation de ladite plaque support par mesure de couplage capacitif entre lesdites secondes électrodes actives et ladite interface de commande.

Les premières et secondes électrodes comprennent en outre respectivement des premières et des secondes électrodes de garde excitées à un potentiel électrique de garde alternatif sensiblement identique à celui des premières et des secondes électrodes actives, lesquelles premières et secondes électrodes de garde étant disposées de telle sorte à blinder électriquement, respectivement, selon leur face orientée vers la plaque support les secondes et premières électrodes actives.

Le dispositif selon l'invention comprend en outre des moyens de commutation permettant de relier des premières et des secondes électrodes, soit aux moyens électroniques de mesure capacitive, soit au potentiel de garde.

Le dispositif selon l'invention comprend en outre des moyens électroniques de mesure capacitive configurés de telle sorte à permettre l'obtention d'informations d'approche et/ou de contact d'objet(s) d'intérêt par mesures de capacité entre des premières électrodes actives et le ou les objet(s) d'intérêt.

Suivant d'autres modes de réalisation, le dispositif selon l'invention peut comprendre en outre des premières électrodes actives avec des électrodes d'excitation et des électrodes de mesures couplées de manière capacitive auxdites électrodes d'excitation, et des moyens électroniques de mesure capacitive configurés de telle sorte à permettre l'obtention d'informations d'approche et/ou de contact d'objet(s) d'intérêt par mesures de variation de capacité de couplage entre lesdites électrodes d'excitation et de mesure.

Le dispositif selon l'invention comprend en outre des moyens électroniques de mesure capacitive configurés de telle sorte à permettre l'obtention de mesures de déplacement et/ou de déformation de ladite plaque support par mesures de capacité entre lesdites secondes électrodes actives et ladite interface de commande.

Le dispositif selon l'invention peut comprendre en outre des moyens électroniques de mesure capacitive au moins en partie référencés à un potentiel électrique de référence flottant par rapport à un potentiel de masse.

Le potentiel électrique de référence peut être sensiblement égal au potentiel de garde.

Suivant un autre aspect, il est proposé un procédé de mesure capacitive pour interfaces de commande, mettant en oeuvre (i) une plaque support en matériau diélectrique avec des moyens de fixation sur une interface de commande, (ii) des premières électrodes en matériau sensiblement conducteur à l'électricité, disposées selon une première face de ladite plaque support à l'opposé de l'interface de commande, lesdites premières électrodes comprenant des premières électrodes actives, (iii) des moyens électroniques de mesure capacitive,
ce procédé comprenant une étape d'obtention d'informations d'approche et/ou de contact d'objet(s) d'intérêt par mesure de couplage capacitif avec lesdites premières électrodes actives,
lequel procédé comprend en outre une étape d'obtention de mesures de déplacement et/ou de déformation de ladite plaque support par mesures de couplage capacitif entre des secondes électrodes actives et ladite interface de commande, lesdites secondes électrodes actives (i) appartenant à un groupe de secondes électrodes en matériau sensiblement conducteur à l'électricité disposées selon une seconde face de ladite plaque support vers l'interface de commande et (ii) étant reliées auxdits moyens électroniques de mesure capacitive.

Le procédé selon l'invention comprend en outre des étapes :
- de liaison, par des moyens de commutation, de premières électrodes aux moyens électroniques de mesure capacitive et de secondes électrodes au potentiel de garde,
- d'obtention d'informations d'approche et/ou de contact d'objet(s) d'intérêt,
- de liaison, par des moyens de commutation, de secondes électrodes aux moyens électroniques de mesure capacitive et de premières électrodes au potentiel de garde,
- d'obtention d'informations de déplacement et/ou de déformation de la plaque support,
- d'obtention d'informations d'approche et/ou de contact d'objet(s) d'intérêt,
- lorsque au moins un objet d'intérêt est à une distance inférieure à une distance prédéterminée, ou en contact avec les premières électrodes, d'obtention d'informations de déplacement et/ou de déformation de la plaque support,
- de détermination d'une force d'appui et/ou d'une pression à partir d'informations de déplacement et/ou de déformation de la plaque support.

Suivant encore un autre aspect, il est proposé un dispositif d'interface homme-machine comprenant une interface de commande et un dispositif de mesure capacitive selon l'invention.

Le dispositif d'interface homme-machine selon l'invention peut comprendre une interface de commande pourvue d'un écran d'affichage, et un dispositif de mesure capacitive pourvu d'une plaque support et d'électrodes sensiblement transparentes.

Suivant encore un autre aspect, il est proposé un appareil, par exemple de l'un des types suivants : smartphone, tablette, écran d'affichage, ordinateur, pad de commande pour machine ou véhicule, comprenant un dispositif d'interface homme-machine selon l'invention.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 illustre une vue schématique, en coupe, d'un dispositif selon l'invention,
- la figure 2 illustre un mode de réalisation d'électronique de détection.

On va décrire un exemple de mode de réalisation de dispositif selon l'invention permettant de fabriquer des interfaces tactiles et sans contact pour des systèmes ou des appareils tels que des téléphones portables (smartphones), des tablettes, des ordinateurs ou des dalles de commande.

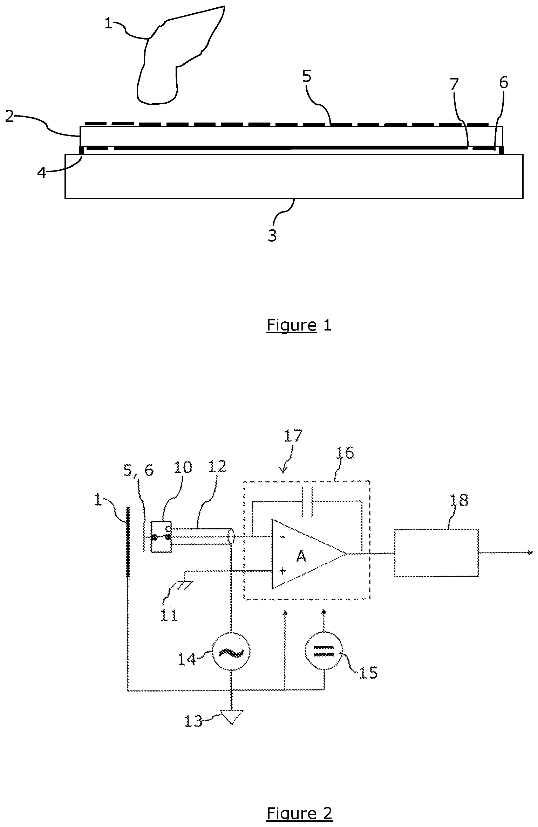

En référence à la figure 1, le dispositif de mesure capacitive selon l'invention comprend une plaque support 2 dans un matériau diélectrique sensiblement transparent tel que du verre ou un polymère comme le PET.

Cette plaque support 2 est fixée sur une interface de commande 3 par des moyens de fixation 4 aptes à se déformer sous l'effet d'une pression. Ces moyens de fixation 4 peuvent comprendre par exemple des ressorts ou des matériaux élastiques.

L'interface de commande 3 comprend un écran d'affichage, par exemple de type TFT (transistor à couches minces) ou OLED (diodes électroluminescentes organiques).

L'interface de commande 3 et le dispositif de mesure capacitive superposé constituent une interface homme-machine pour le système.

La plaque support 2 comprend des premières électrodes 5 réparties sur sa face à l'opposé de l'interface de commande 3. Ces premières électrodes 5 permettent de détecter l'approche et/ou le contact d'un ou plusieurs objet(s) d'intérêt 1 tel qu'un doigt 1 par mesure du couplage capacitif qui s'établit entre elles et le doigt 1.

La distance entre le doigt 1 et les premières électrodes 5 peut être déduite de la mesure du couplage capacitif, tandis que la localisation du doigt 1 dans le plan de la plaque support 2 est obtenue à partir de la position des premières électrodes 5 qui détectent la présence du doigt 1.

La plaque support 2 comprend également des secondes électrodes 6, 7 sur sa face vers l'interface de commande.

Certaines de ces secondes électrodes, ou secondes électrodes actives 6, peuvent être utilisées pour mesurer des distances entre la plaque support 2 et l'interface de commande 3. Ces électrodes 6 sont localisées sur les bords et éventuellement vers le milieu de la plaque support 2.

Les secondes électrodes comprennent également des secondes électrodes de garde 7, excitées à un potentiel électrique de garde alternatif.

Les premières électrodes 5 et les secondes électrodes 6, 7 sont réalisées avec un matériau sensiblement transparent tel que de l'ITO (oxyde d'indium dopé à l'étain) déposées sur la plaque support 2. Certaines électrodes placées en périphérie de la plaque support 2 et hors de la surface transparente peuvent être réalisées dans un matériau non transparent.

La plaque support 2 peut se déformer et/ou se déplacer vers l'interface de commande 3 sous l'effet d'une pression exercée par le doigt 1.

En référence à la figure 2, les premières électrodes 5 et les secondes électrodes actives 6 sont reliées à des moyens électroniques de mesure capacitive 17.

Ces moyens électroniques de mesure capacitive 17, dans le mode de réalisation de la figure 2, sont réalisés sous la forme d'un système de mesure capacitive en pont flottant tel que décrit par exemple dans le document FR 2 756 048 de Rozière.

Le circuit de détection comprend une partie dite flottante 16 dont le potentiel de référence 11, appelé potentiel de garde 11, oscille par rapport à la masse 13 du système global, ou à la terre. La différence de potentiel alternative entre le potentiel de garde 11 et la masse 13 est générée par une source d'excitation, ou un oscillateur 14.

La partie flottante 16 comprend la partie sensible de la détection capacitive, représentée sur la figure 2 par un amplificateur de charge. Elle peut bien entendu comprendre d'autres moyens de traitement et de conditionnement du signal, y compris numériques ou à base de microprocesseur, également référencés au potentiel de garde 11. Ces moyens de traitement et de conditionnement permettent par exemple de calculer des informations de distance et de pression à partir des mesures capacitives.

L'alimentation électrique de la partie flottante 16 est assurée par des moyens flottants de transfert d'alimentation 15, comprenant par exemple des convertisseurs DC/DC.

Ce système de mesure capacitive permet de mesurer une information de capacité entre au moins une électrode de mesure, qui peut être une première électrode 5 ou une seconde électrode active 6, et un objet tel que, respectivement, le doigt 1 ou l'interface de commande 3.

L'objet à détecter doit être relié à un potentiel différent du potentiel de garde 11, tel que par exemple le potentiel de masse 13. On se retrouve bien dans cette configuration pour un doigt 1 d'un utilisateur dont le corps définit une masse, et pour l'interface de commande 3 qui est un système électronique globalement référencé à la masse 13.

Un ensemble de commutateurs ou de switchs analogiques 10, pilotés par des moyens de contrôle électroniques, permet de sélectionner une électrode de mesure 5, 6 et de la relier à l'électronique de détection capacitive 17 pour en mesurer la capacité de couplage avec l'objet 1 ou l'interface de commande 3, respectivement. Les switchs 10 sont configurés de telle sorte qu'une électrode 5, 6 est reliée soit à l'électronique de détection capacitive 17, soit au potentiel de garde 11.

La partie sensible de la détection est protégée par un blindage de garde 12 relié au potentiel de garde 11. De même, les électrodes 5, 6 qui ne sont pas actives sont reliées au potentiel de garde 11 par les switchs 10. Le dispositif comprend en outre des électrodes de garde, dont les secondes électrodes de garde 7, qui sont toujours reliées au potentiel de garde 11.

Ainsi, une électrode active 5, 6 reliée par un switch 10 à l'électronique de détection capacitive 17 est environnée, en particulier selon sa face arrière, par des plans de garde constitués au moins pour partie par des premières et/ou secondes électrodes 5, 6, 7 reliées au potentiel de garde 11.

Comme l'électrode de mesure active 5, 6 est également au potentiel de garde 11, on évite ainsi l'apparition de capacités parasites entre cette électrode et son environnement, de telle sorte que seul le couplage avec l'objet d'intérêt soit mesuré avec une sensibilité maximale.

L'électronique flottante 16 est reliée en sortie à l'électronique du système 18 référencée à la masse par des liaisons électriques compatibles avec la différence de potentiels de référence. Ces liaisons peuvent comprendre par exemple des amplificateurs différentiels ou des optocoupleurs.

On va maintenant décrire un procédé de mesure mis en oeuvre dans le dispositif selon l'invention.

Dans un premier temps, les secondes électrodes 6, 7 sont toutes reliées au potentiel de garde. Les scrutateurs 10 interrogent séquentiellement les premières électrodes actives 5 pour détecter l'approche d'objets de commande 1.

Lorsqu'on identifie un objet de commande à proximité ou en contact avec des premières électrodes 5, les scrutateurs 10 sont pilotés de telle sorte à interroger également des secondes électrodes actives 6. Les mesures obtenues à partir de ces secondes électrodes actives 6 permettent d'obtenir des informations de déplacement et/ou de déformation de la plaque support 2, dont on peut déduire des informations de pression exercée par l'objet de commande 1 sur la plaque support 2.

Lorsque des secondes électrodes actives 6 sont reliées à l'électronique 17, les premières électrodes 5, ou au moins celles placées à l'opposé des secondes électrodes actives 6, sont reliées au potentiel de garde 11.

Grâce à cette disposition des plans de garde, on s'assure que les premières électrodes actives 5 ne sont sensibles qu'à des objets se trouvant de leur côté de la plaque support 2, tandis que les secondes électrodes actives 6 ne sont sensibles qu'à la présence de l'interface de commande 3.

On obtient ainsi des informations sur la position de l'objet, ou des objets 1 dans l'espace relativement à la plaque support 3, et des informations d'appui ou de pression exercée sur cette plaque support 3.

Ces informations sont traitées par l'électronique de détection 17 et transmises à l'électronique du système 18 pour être exploitées notamment dans l'interface homme-machine.

L'information de pression ou d'appui obtenue de manière fiable par le dispositif et le procédé selon l'invention permet d'obtenir une validation des commandes plus sûre et plus confortable pour l'utilisateur. Elle permet également de rajouter une dimension ou un degré de liberté à l'interface homme machine, en permettant une distinction entre un effleurement et un appui, ou même des commandes proportionnelles à la pression exercée.

Suivant des variantes :
- La plaque support 2 peut être suffisamment souple pour se déformer sous l'effet d'une pression exercée, et être fixée par des moyens de fixation 4 élastiques ou rigides ;
- Les premières électrodes 5 et les secondes électrodes 6, 7 peuvent être disposées d'un même côté de la plaque support 2, selon des couches successives séparées par des couches isolantes ;
- les premières et secondes électrodes 5, 6, 7 peuvent être toutes reliées à l'électronique de mesure 17 au moyen de commutateurs 10 ;
- Plusieurs électroniques de mesure 17 peuvent être mises en oeuvre, chacune pouvant être reliée à un ensemble d'électrodes 5, 6, de telle sorte à pouvoir effectuer une pluralité de mesures en parallèle ;
- Des stratégies de scrutation « intelligente» peuvent être mises en oeuvre, pour détecter et suivre des objets 1 avec un minimum d'opérations de scrutation. Inversement, les premières et secondes électrodes actives 5, 6 peuvent toutes être scrutées systématiquement, y compris en l'absence d'objets ;
- Les secondes électrodes actives 6 peuvent être en petit nombre, par exemple vers les bords, et ne détecter que des mouvements globaux de la plaque support 2. Elles peuvent également être en nombre suffisant, réparties sur la surface, pour effectuer une cartographie de la déformation de la plaque support 2 ;
- Les premières électrodes 5 peuvent comprendre des électrodes en forme de lignes et de colonnes croisées, pour des mesures directes de capacité avec l'objet 1, ou des mesures de perturbations de capacité de couplage dues à la présence de l'objet 1 ;
- Les mesures de déplacement et/ou de déformation de la plaque support 2 peuvent comprendre des mesures absolues - par rapport à une position et/ou une forme de référence de la plaque support 2 - et/ou des mesures relatives - c'est-à-dire des mesures de variation de position et/ou de forme -. Elles peuvent également comprendre des mesures de vitesse de déplacement et/ou de déformation de la plaque support 2, ainsi que tous types de mesures relatives à un déplacement et/ou une déformation. Elles peuvent en particulier comprendre des mesures permettant de caractériser une pression exercée de manière statique et/ou dynamique.

Il est à noter que c'est un avantage de l'invention de pouvoir utiliser l'interface de commande 3 globalement comme une « cible ». Cet avantage est rendu possible grâce au fait que l'électronique de détection est référencée à un potentiel de garde 11 alternatif de fréquence définie. Il est ainsi possible de s'affranchir de l'effet des signaux électriques référencés à la masse 13 présents dans l'interface de commande 3.

Suivant un autre aspect avantageux, la plaque support 2 supporte toutes les électrodes 5, 6, 7 et l'invention ne nécessite pas d'adaptation particulière de son environnement pour pouvoir fonctionner. Elle s'intègre ainsi très facilement sur une interface de contrôle 3 sans nécessiter d'adaptation particulière du dispositif d'affichage par exemple.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif de mesure capacitive pour interfaces de commande, comprenant :
- une plaque support (2) en matériau diélectrique, fixée par des moyens de fixation (4) sur une interface de commande (3), qui est un système électronique globalement référencé à la masse (13),
- des premières électrodes (5) en matériau conducteur à l'électricité, disposées selon une première face de ladite plaque support (2) à l'opposé de l'interface de commande (3),
- des secondes électrodes (6, 7) en matériau conducteur à l'électricité, disposées selon une seconde face de ladite plaque support (2) vers l'interface de commande (3),
- des moyens électroniques de mesure capacitive (17) aptes à permettre (i) l'obtention d'informations d'approche et/ou de contact d'objet(s) d'intérêt (1) par mesures de couplage capacitif avec des premières électrodes (5), dites premières électrodes actives, et (ii) l'obtention de mesures de déplacement et/ou de déformation de ladite plaque support (2) par mesure de couplage capacitif entre des secondes électrodes (6), dites secondes électrodes actives, et ladite interface de commande (3),
**caractérisé en ce qu'**il comprend en outre des moyens de commutation (10) permettant de relier des premières, respectivement des secondes électrodes (5, 6) :
- soit aux moyens électroniques de mesure capacitive (17) de sorte à constituer des premières, respectivement des secondes électrodes (5, 6) actives,
- soit à un potentiel électrique de garde (11) alternatif sensiblement identique à celui des premières ou des secondes électrodes (5, 6) actives de sorte à constituer des premières, respectivement des secondes électrodes (5, 6) de garde,
lesquelles premières et/ou secondes électrodes (5, 6) de garde étant agencées par les moyens de commutation (10) de telle sorte à blinder électriquement, au moins selon leur face orientée vers la plaque support (2), des secondes et/ou premières électrodes (6, 5) actives.

2. Le dispositif de la revendication 1, qui comprend en outre des moyens électroniques de mesure capacitive (17) configurés de telle sorte à permettre l'obtention d'informations d'approche et/ou de contact d'objet(s) d'intérêt par mesures de capacité entre des premières électrodes actives (5) et le ou les objet(s) d'intérêt (1).

3. Le dispositif de l'une des revendications 1 ou 2, qui comprend des premières électrodes actives (5) avec des électrodes d'excitation et des électrodes de mesures couplées de manière capacitive auxdites électrodes d'excitation, et des moyens électroniques de mesure capacitive (17) configurés de telle sorte à permettre l'obtention d'informations d'approche et/ou de contact d'objet(s) d'intérêt (1) par mesures de variation de capacité de couplage entre lesdites électrodes d'excitation et de mesure.

4. Le dispositif de l'une des revendications précédentes, qui comprend des moyens électroniques de mesure capacitive (17) configurés de telle sorte à permettre l'obtention de mesures de déplacement et/ou de déformation de ladite plaque support (2) par mesures de capacité entre lesdites secondes électrodes actives (6) et ladite interface de commande (3).

5. Le dispositif de l'une des revendications 1 à 4, qui comprend des moyens électroniques de mesure capacitive (17) au moins en partie référencés à un potentiel électrique de référence flottant par rapport à un potentiel de masse (13).

6. Le dispositif de la revendication 5, dans lequel le potentiel électrique de référence est sensiblement égal au potentiel de garde (11).

7. Procédé de mesure capacitive pour interface de commande, mettant en oeuvre (i) une plaque support (2) en matériau diélectrique fixée par des moyens de fixation (4) sur une interface de commande (3), qui est un système électronique globalement référencé à la masse (13), (ii) des premières électrodes (5) en matériau conducteur à l'électricité, disposées selon une première face de ladite plaque support (2) à l'opposé de l'interface de commande (3), (iii) des secondes électrodes (6, 7) en matériau conducteur à l'électricité, disposées selon une seconde face de ladite plaque support (2) vers l'interface de commande (3), (iv) des moyens électroniques de mesure capacitive (17),
**caractérisé en ce qu'**il comprend des étapes :
- (i) de liaison, avec des moyens de commutation (10), de premières électrodes (5) dites premières électrodes actives aux moyens électroniques de mesure capacitive (17), et de secondes électrodes (6) au potentiel de garde (11), et (ii) d'obtention d'informations d'approche et/ou de contact d'objet(s) d'intérêt (1) par mesure de couplage capacitif avec lesdites premières électrodes actives (5),
- (i) de liaison, avec des moyens de commutation (10), de secondes électrodes (6) dites secondes électrodes actives aux moyens électroniques de mesure capacitive (17), et de premières électrodes (5) au potentiel de garde (11), et (ii) d'obtention de mesures de déplacement et/ou de déformation de ladite plaque support (2) par mesures de couplage capacitif entre lesdites secondes électrodes actives (6) et ladite interface de commande (3).

8. Le procédé de la revendication 7, qui comprend en outre des étapes :
- d'obtention d'informations d'approche et/ou de contact d'objet(s) d'intérêt (1),
- lorsque au moins un objet d'intérêt (1) est à une distance inférieure à une distance prédéterminée ou en contact avec les premières électrodes (5), d'obtention d'informations de déplacement et/ou de déformation de la plaque support (2).

9. Le procédé de l'une des revendications 7 ou 8, qui comprend en outre une étape de détermination d'une force d'appui et/ou d'une pression à partir d'informations de déplacement et/ou de déformation de la plaque support (2).

10. Dispositif d'interface homme-machine comprenant une interface de commande (3) et un dispositif de mesure capacitive selon l'une des revendications 1 à 6.

11. Le dispositif d'interface homme-machine de la revendication 10, qui comprend une interface de commande (3) pourvue d'un écran d'affichage, et un dispositif de mesure capacitive pourvu d'une plaque support (2) et d'électrodes (5, 6, 7) sensiblement transparentes.

12. Appareil de l'un des types suivants : smartphone, tablette, écran d'affichage, ordinateur, pad de commande pour machine ou véhicule, comprenant un dispositif d'interface homme-machine selon l'une des revendications 10 ou 11.

## Patentansprüche

1. Kapazitive Messvorrichtung für Steuerungsschnittstellen umfassend:
eine Trägerplatte (2), aus einem dielektrischen Material, welche mit Befestigungsmitteln (4) mit einer Steuerungsschnittstelle (3) befestigt ist, welche ein elektronisches System ist, das global mit einer Masse (13) verbunden ist,
erste Elektroden (5) aus einem elektrisch leitendem Material, die entlang einer ersten Oberfläche der Trägerplatte (2) gegenüberliegend von der Steuerungsschnittstelle (3) angeordnet sind,
zweite Elektroden (6, 7) aus einem elektrisch leitenden Material, welche entlang einer zweiten Oberfläche der Trägerplatte (2) auf die Steuerungsschnittstelle (3) gerichtet angeordnet sind,
elektronische kapazitive Messmittel (17), die eingerichtet sind zum Erlauben eines (i) Erhalten von Annäherungs- oder Kontaktinformation von einem oder mehreren Objekten von Interesse (1) durch kapazitive Kopplungsmessungen mit den ersten Elektroden (5), die als erste aktive Elektroden bezeichnet werden, und (ii) Erhalten von Bewegungs- und/oder Verformungsmessungen der Trägerplatte (2) durch kapazitive Kopplungsmessungen zwischen den zweiten Elektroden (6), die als zweite aktive Elektroden bezeichnet werden, und der Steuerungsschnittstelle (3),
**dadurch gekennzeichnet, dass** sie ferner Schaltmittel (10) umfasst, die ein jeweiliges Verbinden der ersten und der zweiten Elektroden (5, 6) erlaubt mit:
entweder elektronischen kapazitiven Messmittel (17), um jeweilige erste und zweite aktive Elektroden (5, 6) zu bilden, oder
einem wechselnden elektrischen Schutzpotential (11), welches im Wesentlichen identisch zu dem der ersten oder zweiten aktiven Elektroden (5, 6) ist, um jeweils erste und zweite Schutzelektroden (5, 6) zu bilden,
wobei die ersten und/oder zweiten Schutzelektroden (5, 6) durch die Schaltmittel (10) angeordnet sind, um zweite und/oder erste aktive Elektroden (6, 5) zumindest entlang ihrer Oberflächen, die zu der Trägerplatte (2) hin gerichtet sind, elektrisch abzuschirmen.

2. Vorrichtung nach Anspruch 1, ferner umfassend elektronische kapazitive Messmittel (17), die eingerichtet sind zum Erlauben eines Erhaltens von Annäherungs- und/oder Kontaktinformation von einem oder mehreren Objekten von Interesse durch kapazitives Messen zwischen den ersten aktiven Elektroden (5) und dem einen oder den mehreren Objekten von Interesse (1).

3. Vorrichtung nach einem der Ansprüche 1 oder 2 umfassend erste aktive Elektroden (5) mit Anregungselektroden und Messelektroden, die kapazitiv mit den Anregungselektroden gekoppelt sind, und elektronisch kapazitive Messmittel (17), die eingerichtet sind, zum Erlauben eines Erhaltens von Annäherungs- und/oder Kontaktinformation von einem oder mehreren Objekten von Interesse (1), durch Messen von Variationen der Kopplungskapazität zwischen den Anregungselektroden und den Messelektroden.

4. Vorrichtung nach einem der vorangehenden Ansprüche umfassend elektronische kapazitive Messmittel (17), die eingerichtet sind zum Erlauben eines Erhaltens von Bewegungs- und/oder Verformungsmessungen der Trägerplatte (2) durch kapazitive Messungen zwischen den zweiten aktiven Elektroden (6) und der Steuerungsschnittstelle (3).

5. Vorrichtung nach einem der Ansprüche 1 bis 4, umfassend elektronische kapazitive Messmittel (17), die zumindest teilweise auf ein elektrisches Referenzschwebepotential bezüglich eines Erdungspotentials (13) bezogen sind.

6. Vorrichtung nach Anspruch 5, wobei das elektrische Referenzpotential im Wesentlichen gleich dem Schutzpotential (11) ist.

7. Kapazitives Messverfahren für eine Steuerschnittstelle implementierend (i) eine Trägerplatte (2) aus einem dielektrischen Material, die durch Befestigungsmittel (4) mit einer Steuerungsschnittstelle (3) befestigt ist, welche ein elektronisches System ist, das global mit der Masse (13) verbunden ist, (ii) erste Elektroden (5) aus einem elektrisch leitenden Material, die auf einer ersten Oberfläche der Trägerplatte (2) entgegengesetzt der Steuerungsschnittstelle (3) angeordnet sind, (iii) zweite Elektroden (6, 7) aus einem elektrisch leitendem Material, die entlang einer zweiten Oberfläche der Trägerplatte (2) auf die Steuerungsschnittstelle (3) gerichtet angeordnet sind, (iv) elektronisch kapazitive Messmittel (17), **dadurch gekennzeichnet, dass** es folgende Schritte umfasst:
(i) Verbinden, mit Schaltmitteln (10), der ersten Elektroden (5), die als erste aktive Elektroden bezeichnet werden, mit den elektronischen kapazitiven Messmitteln (17) und der zweiten Elektroden (6) mit dem Schutzpotenzial (11), und (ii) Erhalten von Annäherungs- und/oder Kontaktinformation von einem oder mehreren Objekten von Interesse (1) durch kapazitive Kopplungsmessungen mit den ersten aktiven Elektroden (5),
(i) Verbinden, mit den Schaltmitteln (10), der zweiten Elektroden (6), die als zweite aktive Elektroden bezeichnet werden, mit den elektronischen kapazitiven Messmitteln (17), und der ersten Elektroden (5) mit dem Schutzpotenzial (11) und (ii) Erhalten von Bewegungs- und/oder Verformungsmessungen der Trägerplatte (2) durch kapazitive Kopplungsmessungen zwischen den zweiten aktiven Elektroden (6) und der Steuerungsschnittstelle (3).

8. Verfahren nach Anspruch 7 ferner umfassend die folgenden Schritte:
Erhalten von Annäherungs- und/oder Kontaktinformation von dem einen oder den mehreren Objekten von Interesse (1),
falls das zumindest eine Objekt von Interesse (1) an einer Distanz gelegen ist, die kleiner als eine vorbestimmte Distanz ist oder in Kontakt mit den ersten Elektroden (5) ist, Erhalten von Bewegungs- und/oder Verformungsinformation der Trägerplatte (2).

9. Verfahren nach einem der Ansprüche 7 oder 8, ferner umfassend einen Schritt eines Bestimmens einer Kontaktkraft und/oder einer Druckkraft basierend auf Bewegungs- und/oder Verformungsinformation der Trägerplatte (2).

10. Mensch-Maschinen-Schnittstellenvorrichtung umfassend eine Steuerschnittstelle (3) und eine kapazitive Messvorrichtung gemäß einem der Ansprüche 1 bis 6.

11. Mensch-Maschinen-Schnittstellenvorrichtung des Anspruchs 10 umfassend eine Steuerschnittstelle (3), die mit einer Anzeige und einer kapazitiven Messvorrichtung, die mit einer Trägerplatte (2) und im Wesentlichen transparenten Elektroden (5, 6, 7) bereitgestellt ist, bereitgestellt ist.

12. Vorrichtung nach einem der nachfolgenden Arten: Smartphone, Tablet, Anzeige, Computer, Steuerungspad für eine Maschine oder ein Fahrzeug umfassend eine Mensch-Maschinen-Schnittstellenvorrichtung gemäß einem der Ansprüche 10 oder 11.

## Claims

1. Capacitive measuring device for command interfaces, comprising:
a support plate (2) of a dielectric material, fixed by fixing means (4) to a command interface (3), which is an electronic system globally referenced to a ground (13),
first electrodes (5) of an electrically conducting material, disposed along a first surface of the support plate (2) opposed to the command interface (3),
second electrodes (6, 7) of an electrically conducting material, disposed along a second surface of the support plate (2) facing the command interface (3),
electronic capacitive measuring means (17) configured to allow (i) obtaining approach and/or contact information of one or more objects of interest (1) by capacitive coupling measurements with the first electrodes (5), referred to as first active electrodes, and (ii) obtaining displacement and/or deformation measurements of the support plate (2) by capacitive coupling measurements between the second electrodes (6), referred to as second active electrodes, and the command interface (3),
**characterized in that** it further comprises switching means (10) allowing to respectively connect the first and the second electrodes (5, 6) to:
either electronic capacitive measuring means (17) to respectively form first and second active electrodes (5, 6),
or an alternative electric guard potential (11), substantially identical to the one of the first and second active electrodes (5, 6) to respectively form first and second guard electrodes (5, 6),
wherein the first and/or second guard electrodes (5, 6) are arranged by the switching means (10) to electrically shield second and/or first active electrodes (6, 5) at least along their surface oriented toward the support plate (2).

2. Device according to claim 1, further comprising electronic capacitive measuring means (17) configured to allow obtaining approach and/or contact information of one or more objects of interest by capacitive measurements between the first active electrodes (5) and the one or more objects of interest (1).

3. Device according to one of claims 1 or 2 comprising first active electrodes (5) with excitation electrodes and measurement electrodes capacitively coupled with the excitation electrodes and electronic capacitive measuring means (17) configured to allow obtaining approach and/or contact information of one or more objects of interest (1) by measuring variations of the coupling capacity between the excitation electrodes and the measurement electrodes.

4. Device according to one of the preceding claims comprising electronic capacitive measuring means (17) configured to allow obtaining displacement and/or deformation measurements of the support plate (2) by capacitive measurements between the second active electrodes (6) and the command interface (3).

5. Device according to one of claims 1 to 4, comprising electric capacitive measuring means (17) at least partially referenced to an electric reference floating potential with regard to a ground potential (13).

6. Device according to claim 5, wherein the electric reference potential is substantially equal to the guard potential (11).

7. Capacitive measuring method for a command interface implementing (i) a support plate (2) of a dielectric material fixed by fixing means (4) to a command interface (3) which is an electronic system globally referenced to the ground (13), (ii) first electrodes (5) of an electrically conducting material arranged on a first surface of the support plate (2) opposed to the command interface (3), (iii) second electrodes (6, 7) of an electrically conducting material, arranged along a second surface of the support plate (2) facing the command interface (3), (iv) electronic capacitive measuring means (17),
**characterized in that** it comprises the steps of:
(i) connecting, with switching means (10), the first electrodes (5), referred to as first active electrodes, to the electronic capacitive measuring means (17), and the second electrodes (6) to the guard potential (11), and (ii) obtaining approach and/or contact information of one or more objects of interest (1) by capacitive coupling measurements with the first active electrodes (5),
(i) connecting, with the switching means (10), the second electrodes (6), referred to as second active electrodes, to the electronic capacitive measuring means (17), and the first electrodes (5) to the guard potential (11) and (ii) obtaining displacement and/or deformation measurements of the support plate (2) by capacitive coupling measurements between the second active electrodes (6) and the command interface (3).

8. Method according to claim 7, further comprising the steps of:
obtaining approach and/or contact information of the one or more objects of interest (1),
if at least one object of interest (1) is at a distance shorter than a predetermined distance or is in contact with the first electrodes (5), obtaining displacement and/or deformation information of the support plate (2).

9. Method of one of claims 7 or 8, further comprising a step of determining a contact force and/or a pressure force based on displacement and/or deformation information of the support plate (2).

10. Man-machine interface device comprising a command interface (3) and a capacitive measuring device according to one of claims 1 to 6.

11. Man-machine interface device of claim 10 comprising a command interface (3) provided with a display and a capacitive measuring device provided with a support plate (2) and substantially transparent electrodes (5, 6, 7).

12. Apparatus of one of the following types: smartphone, tablet, display, computer, command pad for a machine or a vehicle, comprising a man-machine interface device according to one of claims 10 or 11.
